# EUROPÄISCHE PATENTSCHRIFT

(11) **EP 1 834 012 B1**
(45) Veröffentlichungstag und Bekanntmachung des Hinweises auf die Patenterteilung: **06.01.2016**
(21) Anmeldenummer: 05792163.7
(22) Anmeldetag: 07.10.2005
(51) Int. Cl.: C25B 1/04, C25B 9/18, H01L 31/052

(54) **VORRICHTUNG UND VERFAHREN ZUR PHOTOVOLTAISCHEN ERZEUGUNG VON WASSERSTOFF**
PHOTOVOLTAIC HYDROGEN GENERATION PROCESS AND DEVICE
DISPOSITIF ET PROCEDE DE PRODUCTION PHOTOVOLTAIQUE D'HYDROGENE

(30) Priorität: 18.10.2004 DE 102004050638
(43) Veröffentlichungstag der Anmeldung: 19.09.2007
(73) Patentinhaber: Fraunhofer-Gesellschaft zur Förderung der angewandten Forschung e.V., 80686 München (DE)
(72) Erfinder: DIMROTH, Frank, 79115 Freiburg (DE)
(74) Vertreter: Pfenning, Meinig & Partner GbR
(86) Internationale Anmeldenummer: PCT/EP2005/010844
(87) Internationale Veröffentlichungsnummer: WO 2006/042650

(56) Entgegenhaltungen:
- EP-A2- 0 829 912
- DE-A1- 3 638 317
- JP-A- 2000 192 275
- US-A- 5 973 825
- US-A1- 2001 035 345

## Beschreibung

Die Erfindung betrifft eine Vorrichtung und ein Verfahren zur photovoltaischen Erzeugung von Wasserstoff aus wasserstoffhaltigen Verbindungen, wobei mittels eines optischen Konzentrators Sonnenlicht auf Solarzellen gebündelt wird und die hierdurch erzeugte Spannung direkt für die Elektrolyse einer wasserstoffhaltigen Verbindung, insbesondere von deionisiertem Wasser, zur Erzeugung von Wasserstoff genutzt wird.

Solarer Wasserstoff kann mit Hilfe von biologischer Wasseraufspaltung durch Bakterien, photoelektrochemische Zellen, aus Biomasse-Reformierung oder durch die solarthermische Aufspaltung von Wasser bei hohen Temperaturen gewonnen werden.

Bisher wird die Elektrolyse von Wasserstoff mittels Photovoltaik meist durch getrennte, hintereinander geschaltete Systeme aus Solarmodul und Elektrolyseur realisiert. Gleiches gilt für Systeme, die Windenergie für die Elektrolyse verwenden. Erstere Systeme werden zum Beispiel auch in dem Übersichtspaper von M. A. K. Lodhi "A Hybrid System of Solar Photovoltaic, Thermal and Hydrogen: A Future Trend" Int. J. Hydrogen Energy, Vol. 20, No. 6, pp. 417-484 (1995) beschrieben. Diese Druckschrift beschreibt auch die Nutzung von konzentrierenden PV-Systemen zur Stromerzeugung und Hybrid-Systemen, die sowohl solar erzeugte Elektrizität als auch Wärme zur Elektrolyse nutzen.

Der Wirkungsgrad der Wasserstofferzeugung ist für all diese System relativ gering und das Verfahren insgesamt teuer. Es gab auch in der Vergangenheit Ideen, Solarzellen direkt zur Elektrolyse von Wasser oder wässriger Lösung einzusetzen, aber die Spannung der meisten Solarzellen im Arbeitspunkt ist zu gering, um die Elektrolyse durchzuführen.

Erstmals wurde die Elektrolyse von Wasser mit Hilfe einer Halbleiter-Elektrode im Juli 1972 in Nature Vol. 238 " Electrochemical Photolysis of Water at a Semiconductor Electrode " von Akira Fijishima und Kenichi Honda beschrieben. Diese Veröffentlichung zeigt, wie man Wasserstoff mit Hilfe von Sonnenlicht aus einer wässrigen Lösung separieren kann. Hierbei wird Wasser in direktem Kontakt mit einer n-leitenden Halbleiterschicht aus TiO₂ und einer Pt-Gegenelektrode gebracht. Bei TiO₂ reicht die im Sonnenlicht erzielte Potentialdifferenz für die Aufspaltung von Wasser. Es wird beschrieben, wie mit diesem photoelektrochemischen Verfahren Wasserstoff und Sauerstoff aus Wasser gewonnen werden können. Wegen der hohen Bandlückenenergie von TiO₂ wird in der Elektrode jedoch nur ein sehr geringer Teil des Sonnenspektrums eingefangen und zur Elektrolyse genutzt. Somit ist dieses Verfahren nicht effizient.

In einem Patent von D.I. Tchernev aus dem Jahre 1975 (US 3,925,212) "Device for Solar Energy Conversion by Photo-Electrolytic Decomposition of Water" wird erstmals gezeigt, dass auch getrennte p- und n-leitende Halbeiterschichten als Elektroden unter Beleuchtung zur Aufspaltung von Wasser genutzt werden können. Auch in dieser Anordnung befinden sich die Halbleiterschichten in direktem Kontakt mit dem Elektrolyten.

Ein weiteres Patent aus dem Jahre 1984 "Photolytic production of hydrogen" US 4,466,869 von A. Williams, beschreibt erstmals, dass die Photoelektrode auch aus einer Schichtstruktur von mehreren übereinander gelagerten Halbleiterschichten mit unterschiedlicher Bandlückenenergie bestehen kann. Damit entspricht die Photoelektrode im Prinzip einer Kaskadensolarzelle, wie sie auch in der hier beschriebenen Erfindung bevorzugt eingesetzt wird. Am National Renewable Energy Laboratory NREL wurde seit 1998 an einem System zur Herstellung von Wasserstoff mittels Sonnenenergie gearbeitet. O. Khaselev, J. A. Turner beschreiben in Science; Vol. 280, April 17 (1998), p.425-427 "A Monolithic Photovoltaic-Photoelectrochemical Device for Hydrogen Production via Water Splitting" ein photoelektrochemisches Verfahren zur Wasseraufspaltung. Hierbei wurde erstmals eine Kaskadensolarzelle aus III-V Halbleitern als eine der Photoelektroden eingesetzt. Die Gegenelektrode bestand aus Platin. Außerdem wurde erstmals der Einsatz von konzentriertem Sonnenlicht erwähnt. Die Halbleiterschichten befinden sich in allen erwähnten Anordnungen in direktem Kontakt mit dem Elektrolyten und stellen selbst eine der Elektroden für die Wasseraufspaltung dar. Die photovoltaische Energieerzeugung und die Elektrolyse von Wasser sind somit nicht räumlich getrennt.

Das Dokument US 5973825 A1 beschreibt eine Vorrichtung und Methode zur Erzeugung von Wasserstoff durch Elektrolyse von Wasserdampf, wobei eine Solarzelle mit Parabolspiegel und optischer Nachführeinrichtung der Elektrolysezelle Strom liefert und die Zelle auf ihre Betriebstemperatur von mindestens 700°C aufgeheizt wird.

Es war daher Aufgabe der vorliegenden Erfindung, ein System zur photovoltaischen Wasserstoffherstellung bereitzustellen, das eine hohe Effizienz bei der Wasserstofferzeugung aufweist und dabei gleichzeitig kostengünstig in der Herstellung ist.

Diese Aufgabe wird durch die Vorrichtung bzw. das Verfahren zur photovoltaischen Erzeugung von Wasserstoff nach Anspruch 1 bzw. 21 gelöst. Die weiteren abhängigen Ansprüche zeigen vorteilhafte Weiterbildungen auf.

Erfindungsgemäß wird eine Vorrichtung zur photovoltaischen Erzeugung von Wasserstoff aus wasserstoffhaltigen Verbindungen bereitgestellt, die aus mehreren dem Stand der Sonne nachgeführten Einheiten besteht, die einen optischen Konzentrator zur Bündelung von Sonnenlicht auf eine Solarzelle, mindestens eine mit den wasserstoffhaltigen Verbindungen nicht in Kontakt stehende Solarzelle, die mit einem Elektrolyseur, der eine mit den wasserstoffhaltigen Verbindungen in Kontakt stehende Anode und eine Kathode aufweist, elektrisch verbunden ist, wobei die Einheiten auf einem dem Stand der Sonne folgenden Nachführsystem angeordnet sind und der Elektrolyseur eine Arbeitstemperatur von -10°C bis 200°C aufweist.

Im Vergleich zu aus dem Stand der Technik bekannten Systemen, bei denen zwei getrennte Systeme zur photovoltaischen Stromerzeugung einerseits und zur Elektrolyse andererseits eingesetzt werden, zeichnet sich das der vorliegenden Erfindung zugrunde liegende System durch die Integration von Solarstromerzeugung und Wasserstoffproduktion in einem System und somit einen geringen Material- und Platzbedarf, eine höhere Effizienz und potentiell geringere Kosten für den solaren Wasserstoff aus. Es entfallen so elektrische Verluste, die üblicherweise durch die Verschaltung von Solarzellen in einem Modul entstehen. Selbst wenn einzelne Zellen innerhalb eines Moduls nicht funktionieren, wird die Funktionsfähigkeit der restlichen Einheiten nicht beeinträchtigt. Ein wesentlicher Vorteil gegenüber photoelektrochemischen Verfahren beruht darauf, dass die Photovoltaikzelle nicht in direktem Kontakt mit dem Elektrolyten steht. Dies kann andernfalls zu erheblichen Problemen, wie z.B. der Oxidation von Halbleiterschichten oder dem Abtrag bzw. der Abscheidung von Material durch die Elektrolyse, führen. Dies verlängert die Langzeitstabilität solcher Systeme. Außerdem werden optische Absorptionsverluste des Sonnenlichts in der wasserstoffhaltigen Verbindung vermieden.

Vorzugsweise weist jede einzelne Einheit der Vorrichtung eine elektrische Leistung von 1 bis 100 W auf.

Der erfindungsgemäße Elektrolyseur weist bevorzugt eine Arbeitstemperatur von 30° C bis 100° C auf.

Vorzugsweise wird als optischer Konzentrator eine punktfokussierende Linse, wie z.B. eine Fresnel-Linse, eingesetzt. Alternativ kann eine gekrümmte Fresnel-Linse mit einem Linienfokus, ein Parabolspiegel mit Linienfokus oder ein Schüsselspiegel mit Punktfokus eingesetzt werden.

Die Solarzelle ist bevorzugt aus mehreren seriell miteinander verschalteten Schichten aus Halbleitermaterialien mit jeweils unterschiedlicher Bandlückenenergie aufgebaut. Die Halbleitermaterialien sind dabei bevorzugt ausgewählt aus der Gruppe bestehend aus Silicium, Germanium und den III-V-Verbindungen von Aluminium, Gallium oder Indium mit Stickstoff, Phosphor, Arsen oder Antimon.

Die Polarität der Solarzelle ist beliebig wählbar, sodass sowohl eine np-Polarität als auch eine pn-Polarität möglich ist. Die Solarzelle kann, wenn lediglich ein pn- oder np-Übergang vorliegt, eine Spannung von mehr als 1,4 Volt, besonders bevorzugt von 1,6 bis 2,4 Volt aufweisen. Weist die Solarzelle mehrere seriell verschaltete pn- oder np-Übergänge auf, so kann eine Spannung im Bereich von 1,5 bis 6 Volt erreicht werden. Die Solarzelle weist dabei vorzugsweise ein Fläche von 0,01 bis 1 cm zum Quadrat auf.

Als Elektrolyseur wird vorzugsweise eine protonendurchlässige Polymermembran (PEM) mit zwei Elektroden, der Kathode und der Anode, eingesetzt.

Vorzugsweise bestehen die Anode und die Kathode aus Edelmetallen, hier insbesondere Platin, Palladium oder Iridium, deren Verbindungen, z.B. Iridiumoxid, oder aus mit Edelmetall beschichteten Metallen, hier insbesondere Nickel, Eisen oder Kupfer. Diese Materialien dienen auch als Katalysator für die Elektrolyse. Die Elektroden können vorzugsweise zusätzlich eine Verteilungsstruktur aufweisen, die zur Verteilung des Stroms auf den Elektroden angeordnet ist. Diese ist bevorzugt ein Metallgitter.

Eine weitere Variante der erfindungsgemäßen Vorrichtung sieht vor, dass die Anode mit einem Kanalsystem verbunden ist, durch das die wasserstoffhaltigen Verbindungen fließen. Die Kathode ist ebenfalls mit einem Kanalsystem oder einem gasdurchlässigen Material verbunden, durch welches der generierte Wasserstoff abgeleitet wird.

Eine weitere Ausführungsform der erfindungsgemäßen Vorrichtung sieht vor, dass der Elektrolyseur aus zwei oder mehr seriell miteinander geschalteten Einheiten mit einer entsprechend höheren Arbeitsspannung besteht.

Erfindungsgemäß wird ebenso ein Verfahren zur Erzeugung von Wasserstoff aus wasserstoffhaltigen Verbindungen bereitgestellt, bei dem Sonnenlicht mittels eines optischen Konzentrators auf mindestens eine Solarzelle gebündelt wird und mit der photovoltaisch erzeugten Spannung die wasserstoffhaltigen Verbindungen bei einer Temperatur bevorzugt im Bereich von 30 °C bis 100 °C elektrolysiert werden, wobei die Solarzelle mit einem Elektrolyseur, mit einer Kathode und/oder einer Anode elektrisch kontaktiert wird und die durch Elektrolyse gebildeten Protonen von der Anode zur Kathode geleitet werden, wo sie zu molekularem Wasserstoff reduziert werden.

Eine bevorzugte Ausführungsform des erfindungsgemäßen Verfahrens sieht vor, dass die wasserstoffhaltigen Verbindungen ebenfalls zur Kühlung eingesetzt werden, indem man die wasserstoffhaltigen Verbindungen an der Solarzelle entlang fließen lässt.

Vorzugsweise enthält die wasserstoffhaltige Verbindung in wesentlichen Teilen deionisiertes Wasser. In diesem Fall ist es dann auch möglich, neben Wasserstoff auch Sauerstoff zu erzeugen.

Anhand der nachfolgenden Figuren soll der erfindungsgemäße Gegenstand näher erläutert werden, ohne diesen auf die hierin gezeigten Ausführungsformen beschränken zu wollen.
Fig. 1 zeigt eine schematische Darstellung des erfindungsgemäßen Verfahrens zur Erzeugung von Wasserstoff.
Fig. 2 zeigt eine erste Ausführungsform der erfindungsgemäßen Vorrichtung.
Fig. 3 zeigt eine erfindungsgemäße Vorrichtung zur photovoltaischen Erzeugung von Wasserstoff als Gesamtsystem.
Fig. 4 zeigt schematisch das Prinzip der Energiewandlung bei dem erfindungsgemäßen Verfahren zur Erzeugung von Wasserstoff.
Fig. 5 zeigt eine zweite Ausführungsform der erfindungsgemäßen Vorrichtung.
Fig. 6 zeigt eine dritte Ausführungsform der erfindungsgemäßen Vorrichtung.
Fig. 7 zeigt den schematischen Aufbau einer erfindungsgemäßen Vorrichtung, bei der eine Elektrolyseeinheit mit mehreren Solarzellen kombiniert ist.

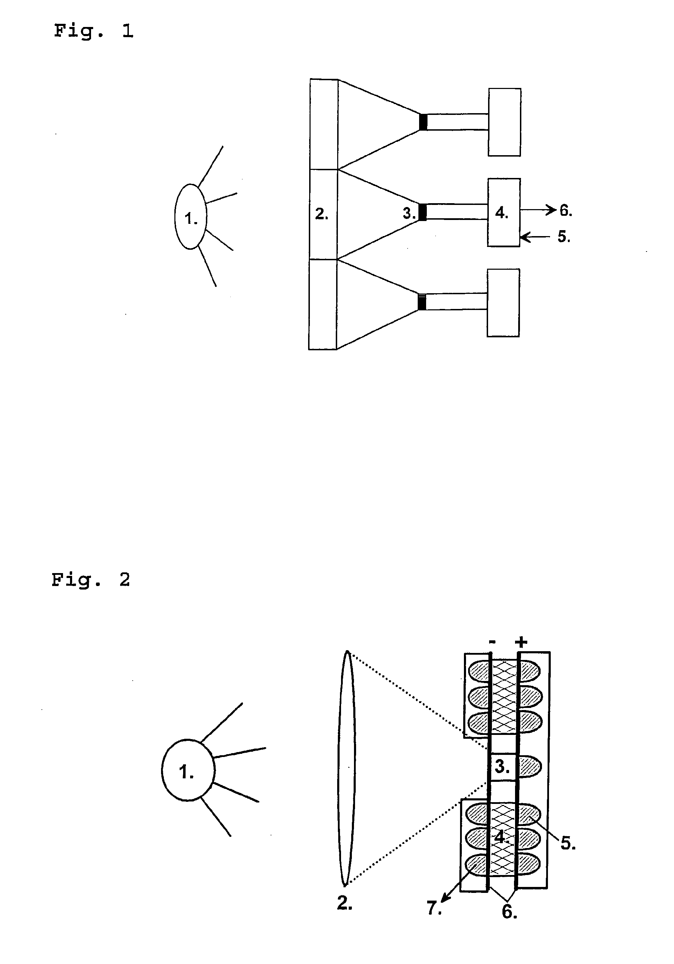

In Fig. 1 wird schematisch das System dargestellt, welches Wasserstoff durch die Elektrolyse von wasserstoffhaltigen Verbindungen, z.B. wässrigen Lösungen, wie deionisiertem Wasser, mit Hilfe von photovoltaisch erzeugter Energie effizient herstellen kann. Dieses System besteht aus einem Konzentrator 2, welcher das Sonnenlicht 1 auf eine Solarzelle 3 bündelt. Der Faktor der Konzentration des Sonnenlichts kann dabei im Bereich von 50 und ca. 1500 liegen. Bevorzugt sind hier Konzentrationen des Sonnenlichts im Bereich von 300 und 1000. Im Brennpunkt des Konzentrators 2 befindet sich eine Solarzelle 3, welche das Sonnenlicht in elektrischen Strom umwandelt. Hierbei werde Spannungen > 1,4 Volt, wie sie für die Elektrolyse notwendig sind, im Arbeitspunkt der Solarzelle erzeugt. Dies kann durch Solarzellen aus III-V-Halbleitern mit einem oder mehreren pn- bzw. np-übergängen realisiert werden. Beispielsweise können als Kaskadensolarzellen solche aus GaInP/GaInAs oder AlGaInAs/Ge verwendet werden. Hierbei sind die Bandlücken der Solarzellen so zu wählen, dass die Strom-Spannungskennlinie der Zelle unter dem konzentrierten Sonnnenspektrum eine möglichst hohe Effizienz für die Elektrolyse der wasserstoffhaltigen Verbindungen erreicht. Die Polarität der Solarzelle kann sowohl p auf n als auch n auf p sein. Die Spannung, die an der Solarzelle 3 anliegt, wird direkt zur Elektrolyse der wasserstoffhaltigen Verbindungen 5 genutzt. Die p- und n-leitenden Schichten der Solarzelle sind direkt mit den Elektroden des Elektrolyseurs 4 verbunden. Der dabei entstehende Wasserstoff 6 wird abgeführt und gespeichert. Wird Wasser für die Elektrolyse verwendet, so kann auch Sauerstoff als weiteres Gas gewonnen werden. Jede einzelne Solarzelle in dem in Fig. 1 dargestellten System ist direkt mit einem Elektrolyseur verbunden. Es ist aber auch möglich, dass bis zu 4 Solarzellen oder auch mehr mit einem einzigen Elektrolyseur direkt verbunden sind. Weiter ist es möglich, dass der Elektrolyseur aus zwei seriell hintereinander geschalteten Elektrolyseeinheiten besteht, wodurch die Arbeitsspannung verdoppelt wird. Wesentlich für die Erfindung ist die Integration mehrerer separater Konzentrator-Solarzellen-Elektrolyseur-Einheiten in einem Gesamtsystem. Diese Einheiten können dann (müssen aber nicht) komplett elektrisch voneinander getrennt sein. Sie sind dabei auf einer Nachführeinheit angeordnet und werden der Sonne nachgeführt.

In Fig. 2 ist eine erste Ausführungsform einer erfindungsgemäßen Vorrichtung zur photovoltaischen Erzeugung von Wasserstoff dargestellt. Diese Vorrichtung besteht aus einer Fresnel-Linse 2, welche das Sonnenlicht 1 um einen Faktor 300 oder mehr konzentriert und auf eine Kaskadensolarzelle 3 aus III-V-Halbleitern lenkt. Die Fläche der Solarzelle beträgt dabei zwischen 0,01 bis 1 cm². In der Solarzelle wird das konzentrierte Sonnenlicht mit einer hohen Effizienz von mehr als 30 % in elektrische Energie umgewandelt. Die Spannung der Solarzelle im Arbeitspunkt ist dabei > 1,4 Volt.

Bisher wurden die III-V-Materialien für die terrestrische Energieerzeugung nicht eingesetzt, da sie zu teuer sind. Durch die Verwendung von konzentriertem Licht wird die Halbleiterfläche jedoch deutlich verringert und der Einsatz wird rentabel. Dies soll in Zukunft auch für die solare Stromerzeugung auf der Erde genutzt werden. Das Fraunhofer ISE arbeitet in diesem Zusammenhang seit einigen Jahren an dem sog. FLATCON^{™} Konzentrator. Dieses System verwendet ebenfalls Kaskadensolarzellen unter konzentriertem Sonnenlicht für die Erzeugung von elektrischem Strom.

In einer Kaskadensolarzelle werden mehrere Schichten aus III-V-Halbleitern unterschiedlicher Bandlückenenergie übereinander abgeschieden. Diese Teilzellen werden monolithisch, d.h. auf dem Substrat, seriell miteinander verschaltet. Hierdurch lassen sich Arbeitsspannungen zwischen 1 Volt für eine Einfachsolarzelle und etwa 6 Volt für eine Solarzelle mit 5-6 seriell verschalteten pn-Übergängen realisieren. Solarzellen mit 3 pn-Ubergängen haben Effizienzen von bis zu 37 % für die Umwandlung des konzentrierten Sonnenlichts in elektrische Energie erreicht (R. King et al. "Metamorphic III-V-Materials" Proc. of 19th European Photovoltaic Solar Energy Conference, Paris 2004). Die Kombination der Bandlücken und Materialien für die hier beschriebene Anwendung muss hinsichtlich einer Maximierung der Effizienz für die Elektrolyse von Wasser neu optimiert werden. Beispiele für mögliche Materialkombinationen sind z.B. GaInP/GaInAs, GaAs/Ge, AlGaInAs/Ge, AlGaAs/Si, GaInP/GaInAs/Ge, AlGaInP/GaAs/GaInNAs/Ge oder AlGaInP/GaIn/AlGaInAs/GaInAsN/Ge. Neben dem geringeren Materialverbrauch liegt ein weiterer Vorteil des Einsatzes von konzentriertem Licht darin, dass die Spannung einer Solarzelle logarithmisch mit der Konzentration steigt.

Der Vorder- und Rückseitenkontakt der Solarzelle wird direkt über ein Metallgitter 6 mit Elektroden (z.B. aus Edelmetallen wie Platin, Palladium, Iridium oder Iridiumoxid, die auch als Katalysator für die Elektrolyse dienen oder aus mit solchen Edelmetallen beschichteten Nickel-, Eisen- oder Kupfer-Elektroden) auf einer protonendurchlässigen Polymermembran (PEM) 4 verbunden. Die Fläche der PEM-Membran kann sich bis auf die gesamte Einfallsfläche des Sonnenlichts (außer der Fläche der Solarzelle) erstrecken. Die PEM-Membran kann aber auch nur eine viel kleinere Fläche einnehmen. Die Membran ist auf der positiven Seite der Anode in direktem Kontakt mit der wasserstoffhaltigen Lösung, die z.B. aus deionisiertem Wasser 5 besteht. Es können aber auch andere Lösungen verwendet werden, die auch nicht notwendigerweise transparent sein müssen. Die Lösung wird in einer möglichen Anordnung zunächst unter den Solarzellen hindurchfließen und trägt dort zur Kühlung bei. Hierdurch kann die Effizienz der Solarzellen gesteigert werden. Anschließend wird die Lösung durch ein Kanalsystem zur Anode geleitet und dort in Sauerstoff und Wasserstoffionen aufgespalten. Die auf der Anodenseite entstehenden Sauerstoffmoleküle steigen innerhalb der Flüssigkeit auf und können dort gesammelt werden. Die H⁺-Ionen wandern durch die PEM-Membran zur negativen Kathode, wo sie mit je zwei Elektronen zu molekularem Wasserstoff reagieren. Die Kathodenseite ist wieder mit einem Kanalsystem, durch das die wasserstoffhaltige Lösung fließt, oder mit einem gasdurchlässigen, bzw. porösen Material abgedeckt, durch welches der Wasserstoff zum Speicher geleitet werden kann.

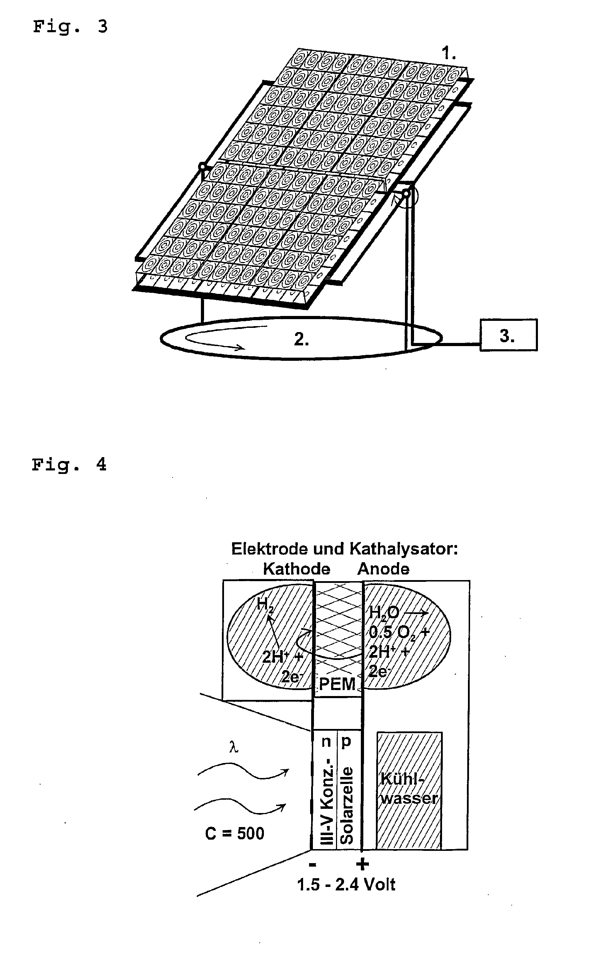

Fig. 3 zeigt eine erfindungsgemäße Vorrichtung 1, die zu einem Gesamtsystem zur photovoltaischen Erzeugung von Wasserstoff zusammengestellt sind. Die Gase werden hier am oberen Rand der einzelnen Module gesammelt und einem Speicher 3 zugeführt. Dieser Speicher kann z.B. aus Druckgasflaschen bestehen. Die Zuleitung zu den Modulen kann evakuiert sein. Die Module werden auf einer 2-achsigen Nachführeinheit 2 montiert, die dem Lauf der Sonne folgt. Die ist notwendig, um den Brennfleck der Linse immer genau auf der Solarzelle zu halten. Da PEM-Elektrolyseure Wirkungsgrade von 80 bis 90 % erzielen, können mit dem hier beschriebenen System aus III-V-Kaskadensolarzellen und PEM-Elektrolyseursystemwirkungsgrade von 27 % für die Erzeugung von Wasserstoff mittels Sonnenlicht erreicht werden.

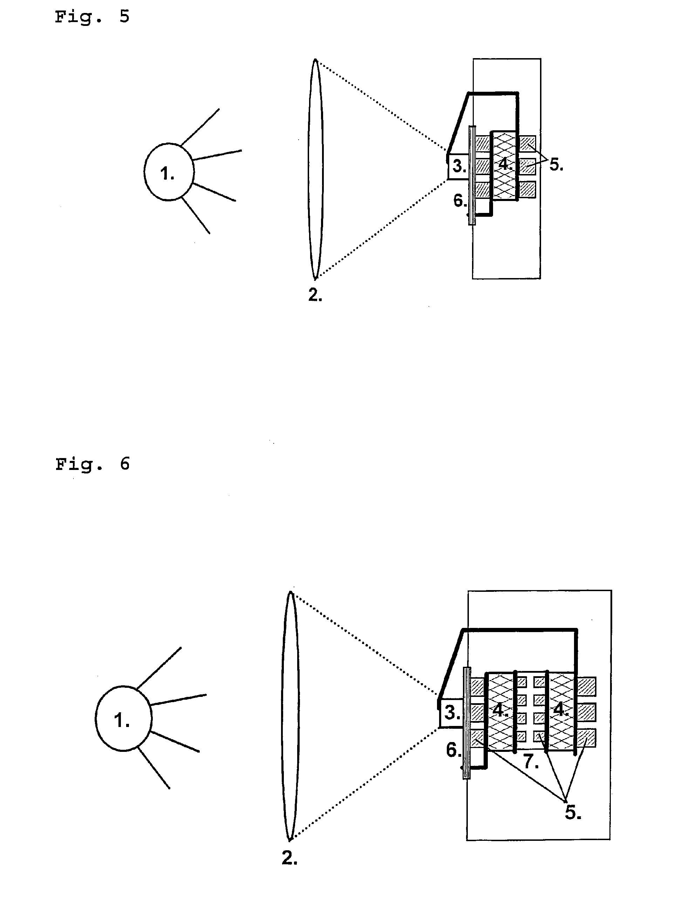

In Fig. 4 wird das Prinzip der Energiewandlung schematisch dargestellt. An der Anode wird z.B. durch einen Kanal wasserstoffhaltige Verbindung entlang geführt. Hierbei kommt es dann zur Spaltung von Wasser zu Sauerstoff und Protonen. Die Protonen wiederum können die protonendurchlässige Polymermembran (PEM) passieren und gelangen so zur Kathode. Hier kommt es zur Reduktion der Protonen zu molekularem Wasserstoff. Im vorliegenden Beispiel ist die Polymermembran benachbart zur Solarzelle angeordnet. Die Solarzelle kann zusätzlich von der Rückseite durch einen mit Kühlwasser durchströmten Kanal gekühlt werden. Fig. 5 zeigt eine weitere Ausführungsform der Erfindung, bei der der PEM-Elektrolyseur 4 unter der Solarzelle 3 angeordnet ist. Das Wasser strömt hier direkt durch Kanäle 5 unter der Solarzelle hindurch, die auf eine Cu-Platte 6 aufgelötet sind. Die Cu-Platte kann dabei zum Wasser hin durch einen Isolator elektrisch getrennt sein. Es besteht ein guter thermischer Kontakt zwischen dem Wasser für die Elektrolyse und der Solarzelle. Wasserstoff und Sauerstoff werden in diesem Fall als Gasblasen in der Flüssigkeit transportiert.

In einer weiteren Ausführung der hier beschriebenen Erfindung werden zwei Elektrolyseeinheiten seriell verschalten. Dies ist sinnvoll, wenn die Spannung der Konzentrator-Solarzelle im Arbeitspunkt das doppelte der für die Elektrolyse notwendigen Spannung, also etwa 3 Volt, erreicht. Solch hohe Spannungen können mit einer einzigen hocheffizienten Kaskadensolarzelle aus III-V-Halbleitern erreicht werden. Ein möglicher Aufbau für die serielle Verschaltung zweier PEM-Elektrolyse-Einheiten ist in Fig. 6 gezeigt. In dieser Figur bedeuten:
1 Sonne
2 Punktfokussierende Linse
3 III- bis V-Kaskadensolarzelle
4 PEM-Membran mit Elektroden
5 Wasser oder wasserstoffhaltige Lösung für die Elektrolyse zum Kühlen der Solarzelle
6 Metallplatte aus Cu als Träger für die Solarzelle
7 Strukturierter, leitfähiger Separator zwischen den beiden PEM-Membranen mit Wasserkanälen, z.B. aus Titan

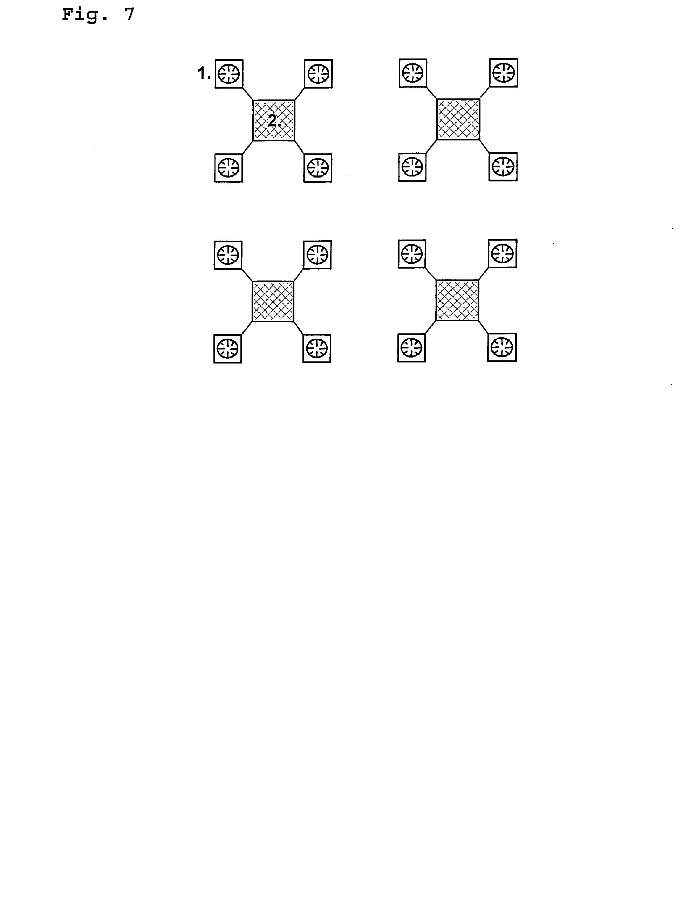

In einer weiteren Ausführung der Erfindung werden je zwei bis vier Konzentrator-Solarzellen mit nur einem Elektrolyseur verbunden (siehe Fig. 7). Diese Anordnung eignet sich, wenn der von einer Konzentrator-Solarzelle generierte Strom nicht ausreicht, um den Elektrolyseur effizient zu betreiben. Die Anordnungen von Fig. 2 und Fig. 7 oder Fig. 5 und Fig. 7 können auch miteinander kombiniert werden.

## Patentansprüche

1. Vorrichtung zur Erzeugung von Wasserstoff aus wasserstoffhaltigen Verbindungen enthaltend mehrere Einheiten aus jeweils mindestens einem optischen Konzentrator zur Bündelung von Sonnenlicht auf mindestens eine Solarzelle, mindestens eine mit den wasserstoffhaltigen Verbindungen nicht in Kontakt stehende Solarzelle, die mit einem Elektrolyseur, der eine mit den wasserstoffhaltigen Verbindungen in Kontakt stehende Anode und eine Kathode aufweist, elektrisch verbunden ist, wobei die Einheiten auf einem dem Stand der Sonne folgenden Nachführsystem angeordnet sind und der Elektrolyseur eine Arbeitstemperatur von -10 °C bis 200 °C aufweist.

2. Vorrichtung nach Anspruch 1,
**dadurch gekennzeichnet, dass** jede Einheit eine elektrische Leistung von weniger als 100 Watt aufweist.

3. Vorrichtung nach Anspruch 1 oder 2,
**dadurch gekennzeichnet, dass** der Elektrolyseur eine Arbeitstemperatur von 30 °C bis 100 °C aufweist.

4. Vorrichtung nach einem der vorhergehenden Ansprüche,
**dadurch gekennzeichnet, dass** der optische Konzentrator eine punktfokussierende Linse, insbesondere eine Fresnel-Linse, oder eine linienfokussierende Linse ist.

5. Vorrichtung nach einem der vorhergehenden Ansprüche,
**dadurch gekennzeichnet, dass** der optische Konzentrator ein Parabolspiegel mit einem Linienfokus ist.

6. Vorrichtung nach einem der vorhergehenden Ansprüche,
**dadurch gekennzeichnet, dass** der optische Konzentrator ein Schüsselspiegel mit einem Punktfokus ist.

7. Vorrichtung nach einem der vorhergehenden Ansprüche,
**dadurch gekennzeichnet, dass** die Solarzelle aus mehreren seriell miteinander verschalteten Schichten aus Halbleitermaterialien mit jeweils unterschiedlicher Bandlückenenergie besteht.

8. Vorrichtung nach dem vorhergehenden Anspruch,
**dadurch gekennzeichnet, dass** die Halbleitermaterialien ausgewählt sind aus der Gruppe bestehend aus Silicium, Germanium und III-V-Verbindungen von Aluminium, Gallium, Indium sowie Stickstoff, Phosphor, Arsen und Antimon.

9. Vorrichtung nach dem vorhergehenden Anspruch,
**dadurch gekennzeichnet, dass** die Solarzelle eine np-Polarität aufweist.

10. Vorrichtung nach einem der Ansprüche 1 bis 8,
**dadurch gekennzeichnet, dass** die Solarzelle eine pn-Polarität aufweist.

11. Vorrichtung nach einem der vorhergehenden Ansprüche,
**dadurch gekennzeichnet, dass** die Solarzelle einen pn- oder np-Übergang aufweist und eine Spannung von mehr als 1,4 V, insbesondere von 1,6 bis 2,4 V besitzt.

12. Vorrichtung nach einem der vorhergehenden Ansprüche,
**dadurch gekennzeichnet, dass** die Solarzelle mehrere seriell verschaltete pn- oder np-Übergänge aufweist und eine Spannung im Bereich von 1,5 bis 6 V besitzt.

13. Vorrichtung nach einem der vorhergehenden Ansprüche,
**dadurch gekennzeichnet, dass** die Solarzelle eine Fläche von 0,01 bis 1 cm² besitzt.

14. Vorrichtung nach einem der vorhergehenden Ansprüche,
**dadurch gekennzeichnet, dass** der Elektrolyseur eine protonendurchlässige Polymermembran (PEM) enthält, die in direktem Kontakt mit der Kathode und der Anode steht.

15. Vorrichtung nach einem der vorhergehenden Ansprüche,
**dadurch gekennzeichnet, dass** die Anode und die Kathode aus Edelmetallen, insbesondere Platin, Palladium und Iridium, deren Verbindungen, insbesondere Iridiumoxid, oder aus mit Edelmetallen beschichteten Metallen, insbesondere Nickel, Eisen oder Kupfer besteht.

16. Vorrichtung nach einem der vorhergehenden Ansprüche,
**dadurch gekennzeichnet, dass** auf den Elektroden eine Verteilungsstruktur, insbesondere ein Metallgitter, zur Verteilung des Stroms angeordnet ist.

17. Vorrichtung nach einem der vorhergehenden Ansprüche,
**dadurch gekennzeichnet, dass** an der Kathode mindestens ein Kanal oder ein gasdurchlässiges Material zur Ableitung des generierten Wasserstoffs angeordnet ist.

18. Vorrichtung nach einem der beiden vorhergehenden Ansprüche,
**dadurch gekennzeichnet, dass** der Kanal und/oder die Beschichtung auf der dem Licht zugewandten Seite lichtundurchlässig oder verspiegelt ist.

19. Vorrichtung nach einem der vorhergehenden Ansprüche,
**dadurch gekennzeichnet, dass** die wasserstoffhaltige Verbindung in wesentlichen Teilen aus deionisiertem Wasser ist.

20. Vorrichtung nach einem der vorhergehenden Ansprüche,
**dadurch gekennzeichnet, dass** der Elektrolyseur aus mehreren seriell verschaltete Einheiten aus Elektroden und protonendurchlässiger Membran besteht.

21. Verfahren zur Erzeugung von Wasserstoff aus wasserstoffhaltigen Verbindungen, bei dem Sonnenlicht mittels eines optischen Konzentrators auf mindestens eine Solarzelle gebündelt wird und mit der photovoltaisch erzeugten Spannung die wasserstoffhaltigen Verbindungen elektrolysiert werden und die durch Elektrolyse gebildeten Protonen von der Anode zur Kathode geleitet werden, wo sie zu molekularem Wasserstoff reduziert werden, wobei mehrere, dem Stand der Sonne nachgeführte Einheiten bestehend aus mindestens einem Konzentrator und mindestens einer mit den wasserstoffhaltigen Verbindungen nicht in Kontakt stehenden Solarzelle, die mit einem Elektrolyseur mit einer Kathode und einer Anode elektrisch kontaktiert wird, verwendet werden, wobei der Elektrolyseur eine Arbeitstemperatur von -10°C bis 200°C aufweist.

22. Verfahren nach Anspruch 21,
**dadurch gekennzeichnet, dass** Solarzellen aus mehreren seriell miteinander verschalteten pn- oder np-Übergängen aus Halbleitermaterialien mit jeweils unterschiedlicher Bandlückenenergie verwendet werden.

23. Verfahren nach einem der Ansprüche 21 oder 22,
**dadurch gekennzeichnet, dass** die Halbleitermaterialien ausgewählt sind aus der Gruppe bestehend aus Silicium, Germanium und III-V-Verbindungen von Aluminium, Gallium oder Indium sowie Stickstoff, Phosphor, Arsen oder Antimon.

24. Verfahren nach einem der Ansprüche 21 bis 23,
**dadurch gekennzeichnet, dass** die Zahl der pn- oder np-Übergänge der Solarzelle so gewählt wird, dass die Solarzelle eine Spannung im Bereich von 1,5 bis 6 V aufweist.

25. Verfahren nach einem der Ansprüche 21 bis 24,
**dadurch gekennzeichnet, dass** das Licht um den Faktor 50 bis 1500, insbesondere um den Faktor 300 bis 1000 gebündelt wird.

26. Verfahren nach einem der Ansprüche 21 bis 25,
**dadurch gekennzeichnet, dass** das Licht mit einer punktfokussierenden optischen Linse, insbesondere einer Fresnel-Linse, einem punktfokussierenden Schüsselspiegel, einer linienfokussierenden optischen Linse oder einem Parabolspiegel gebündelt wird.

27. Verfahren nach einem der Ansprüche 21 bis 26,
**dadurch gekennzeichnet, dass** als Elektrolyseur eine protonendurchlässige Polymermembran verwendet wird.

28. Verfahren nach einem der Ansprüche 21 bis 27,
**dadurch gekennzeichnet, dass** der Wasserstoff aus den Einheiten zusammengeführt und gesammelt wird.

29. Verfahren nach einem der Ansprüche 21 bis 28,
**dadurch gekennzeichnet, dass** der generierte Wasserstoff über ein Kanalsystem abgeleitet wird.

30. Verfahren nach einem der Ansprüche 21 bis 29,
**dadurch gekennzeichnet, dass** die wasserstoffhaltigen Verbindungen zur Kühlung eingesetzt werden, indem man die wasserstoffhaltigen Verbindungen an den Solarzellen entlang fließen lässt.

31. Verfahren nach einem der Ansprüche 21 bis 30,
**dadurch gekennzeichnet, dass** als Nebenprodukt molekularer Sauerstoff erzeugt wird.

32. Verfahren nach einem der Ansprüche 21 bis 31,
**dadurch gekennzeichnet, dass** die wasserstoffhaltige Verbindung in wesentlichen Teilen aus deionisiertem Wasser besteht.

## Claims

1. Device for the generation of hydrogen from hydrogen-containing compounds, comprising a plurality of units made of respectively at least one optical concentrator for concentrating sunlight onto at least one solar cell, at least one solar cell being not in contact with the hydrogen-containing compounds and being electrically connected to an electrolysis unit having an anode in contact with the hydrogen-containing compounds and a cathode, wherein the units are disposed on a tracking system following the position of the sun and the electrolysis unit has an operating temperature of -10°C to 200°C.

2. Device according to claim 1, **characterised in that** each unit has an electrical power of less than 100 watts.

3. Device according to claim 1 or 2, **characterised in that** the electrolysis unit has an operating temperature 30°C to 100°C.

4. Device according to one of the preceding claims, **characterised in that** the optical concentrator is a point-focusing lens, in particular a Fresnel lens, or a line-focusing lens.

5. Device according to one of the preceding claims, **characterised in that** the optical concentrator is a parabolic mirror with a line focus.

6. Device according to one of the preceding claims, **characterised in that** the optical concentrator is a dished mirror with a point focus.

7. Device according to one of the preceding claims, **characterised in that** the solar cell consists of a plurality of layers of semiconductor materials which are connected to each other in series and have respectively different band gap energy.

8. Device according to the preceding claim, **characterised in that** the semiconductor materials are selected from the group consisting of silicon, germanium and III-V compounds of aluminium, gallium, indium and also nitrogen, phosphorus, arsenic and antimony.

9. Device according to the preceding claim, **characterised in that** the solar cell has an np polarity.

10. Device according to one of the claims 1 to 8, **characterised in that** the solar cell has a pn polarity.

11. Device according to one of the preceding claims, **characterised in that** the solar cell has a pn or np transition and a voltage of more than 1.4 V, in particular of 1.6 to 2.4 V.

12. Device according to one of the preceding claims, **characterised in that** the solar cell has a plurality of series-connected pn or np transitions and has a voltage in the range of 1.5 to 6 V.

13. Device according to one of the preceding claims, **characterised in that** the solar cell has an area of 0.01 to 1 cm².

14. Device according to one of the preceding claims, **characterised in that** the electrolysis unit contains a proton-permeable polymer membrane (PEM) which is in direct contact with the cathode and the anode.

15. Device according to one of the preceding claims, **characterised in that** the anode and the cathode consist of noble metals, in particular platinum, palladium and iridium, the compounds thereof, in particular iridium oxide, or of metals coated with noble metals, in particular nickel, iron or copper.

16. Device according to one of the preceding claims, **characterised in that** a distribution structure, in particular a metal grating, is disposed on the electrodes in order to distribute the current.

17. Device according to one of the preceding claims, **characterised in that** at least one channel or a gas-permeable material is disposed at the cathode in order to discharge the generated hydrogen.

18. Device according to one of the two preceding claims, **characterised in that** the channel and/or the coating on the side orientated towards the light is light-impermeable or mirrored.

19. Device according to one of the preceding claims, **characterised in that** the hydrogen-containing compound is of deionised water in substantial parts.

20. Device according to one of the preceding claims, **characterised in that** the electrolysis unit consists of a plurality of series-connected units consisting of electrodes and proton-permeable membranes.

21. Method for the generation of hydrogen from hydrogen-containing compounds, in which sunlight is concentrated on at least one solar cell by means of an optical concentrator and, with the photovoltaically generated voltage, the hydrogen-containing compounds are electrolysed and the protons formed by the electrolysis are conducted from the anode to the cathode where they are reduced to form molecular hydrogen, wherein a plurality of units are used which track the position of the sun and consist of at least one concentrator and at least one solar cell not being in contact with the hydrogen-containing compounds and being contacted electrically with an electrolysis unit having a cathode and an anode, wherein the electrolysis unit has an operating temperature of -10°C to 200°C.

22. Method according to claim 21, **characterised in that** solar cells consisting of a plurality of pn or np transitions which are connected to each other in series and consist of semiconductor materials which have respectively different band gap energy are used.

23. Method according to one of the claims 21 or 22, **characterised in that** the semiconductor materials are selected from the group consisting of silicon, germanium and III-V compounds of aluminium, gallium or indium and also nitrogen, phosphorus, arsenic or antimony.

24. Method according to one of the claims 21 to 23, **characterised in that** the number of pn or np transitions of the solar cell is chosen such that the solar cell has a voltage in the range of 1.5 to 6 V.

25. Method according to one of the claims 21 to 24, **characterised in that** the light is concentrated by the factor 50 to 1500, in particular by the factor 300 to 1000.

26. Method according to one of the claims 21 to 25, **characterised in that** the light is concentrated with a point-focusing optical lens, in particular a Fresnel lens, a point-focusing dished mirror, a line-focusing optical lens or a parabolic mirror.

27. Method according to one of the claims 21 to 26, **characterised in that** a proton-permeable polymer membrane is used as electrolysis unit.

28. Method according to one of the claims 21 to 27, **characterised in that** the hydrogen from the units is assembled and collected.

29. Method according to one of the claims 21 to 28, **characterised in that** the generated hydrogen is discharged via a channel system.

30. Method according to one of the claims 21 to 29, **characterised in that** the hydrogen-containing compounds are used for cooling **in that** the hydrogen-containing compounds are made to flow along the solar cells.

31. Method according to one of the claims 21 to 30, **characterised in that** molecular oxygen is generated as by-product.

32. Method according to one of the claims 21 to 31, **characterised in that** the hydrogen-containing compound consists of deionised water in substantial parts.

## Revendications

1. Dispositif permettant de produire de l'hydrogène à partir de composés contenant de l'hydrogène, contenant plusieurs unités constituées chacune d'au moins un concentrateur optique pour la concentration de la lumière solaire sur au moins une cellule photovoltaïque, au moins une cellule photovoltaïque qui n'est pas en contact avec les composés contenant de l'hydrogène, qui est reliée électriquement avec un électrolyseur qui comprend une anode en contact avec les composés contenant de hydrogène et une cathode, les unités étant disposées sur un système de poursuite suivant la position du soleil et l'électrolyseur présentant une température de travail de -10°C à 200°C.

2. Dispositif selon la revendication 1,
**caractérisé en ce que** chaque unité présente une puissance électrique inférieure à 100 Watt.

3. Dispositif selon la revendication 1 ou 2,
**caractérisé en ce que** l'électrolyseur présente une température de travail de 30°C à 100°C.

4. Dispositif selon l'une des revendications précédentes,
**caractérisé en ce que** le concentrateur optique est une lentille à foyer ponctuel, plus particulièrement une lentille de Fresnel ou une lentille foyer linéaire.

5. Dispositif selon l'une des revendications précédentes,
**caractérisé en ce que** le concentrateur optique est un miroir parabolique avec un foyer linéaire.

6. Dispositif selon l'une des revendications précédentes,
**caractérisé en ce que** le concentrateur optique est un miroir en forme de cuvette avec un foyer ponctuel.

7. Dispositif selon l'une des revendications précédentes,
**caractérisé en ce que** la cellule photovoltaïque est constituée de plusieurs couches connectées entre elles en série et constituées de matériaux semi-conducteurs avec chacun une énergie de bande interdite différente des autres.

8. Dispositif selon l'une des revendications précédentes,
**caractérisé en ce que** les matériaux semi-conducteurs sont sélectionnés dans le groupe constitué du silicium, du germanium et de composés III-V d'aluminium, de gallium, d'indium ainsi que d'azote, de phosphore, d'arsenic ou d'antimoine.

9. Dispositif selon l'une des revendications précédentes,
**caractérisé en ce que** la cellule photovoltaïque présente une polarité np.

10. Dispositif selon l'une des revendications 1 à 8,
**caractérisé en ce que** la cellule photovoltaïque présente une polarité pn

11. Dispositif selon l'une des revendications précédentes,
**caractérisé en ce que** la cellule photovoltaïque présente une transition pn ou np et une tension supérieure à 1,4 V, plus particulièrement de 1,6 V à 2,4 V.

12. Dispositif selon l'une des revendications précédentes,
**caractérisé en ce que** la cellule photovoltaïque comprend plusieurs transitions pn ou np connectées entre elles en série et une tension de l'ordre de 1,5 à 6 V.

13. Dispositif selon l'une des revendications précédentes,
**caractérisé en ce que** la cellule photovoltaïque présente une surface de 0,01 à 1 cm².

14. Dispositif selon l'une des revendications précédentes,
**caractérisé en ce que** l'électrolyseur contient une membrane polymère perméable aux protons (PEM) qui est en contact direct avec la cathode et l'anode.

15. Dispositif selon l'une des revendications précédentes,
**caractérisé en ce que** l'anode et la cathode sont constituées de métaux nobles, plus particulièrement de platine, de palladium et d'iridium, de leurs composés, plus particulièrement de l'oxyde d'iridium, ou de métaux revêtus de métaux nobles, plus particulièrement du nickel, du fer ou du cuivre.

16. Dispositif selon l'une des revendications précédentes,
**caractérisé en ce que**, sur les électrodes, se trouve une structure de répartition, plus particulièrement une grille métallique pour la répartition du courant.

17. Dispositif selon l'une des revendications précédentes,
**caractérisé en ce que**, au niveau de la cathode, se trouve au moins un canal ou un matériau perméable aux gaz pour l'évacuation de l'hydrogène généré.

18. Dispositif selon l'une des deux revendications précédentes,
**caractérisé en ce que** le canal et/ou le revêtement n'est pas transparent ou est réfléchissant du côté orienté vers la lumière.

19. Dispositif selon l'une des deux revendications précédentes,
**caractérisé en ce que** le composé contenant de l'hydrogène est constitué principalement d'eau dé-ionisée.

20. Dispositif selon l'une des deux revendications précédentes,
**caractérisé en ce que** l'électrolyseur est constitué de plusieurs unités connectées en série, constituées d'électrodes et d'une membrane perméable aux protons.

21. Procédé de production d'hydrogène à partir de composés contenant de l'hydrogène, dans lequel la lumière du soleil est concentrée au moyen d'un concentrateur optique sur au moins une cellule photovoltaïque et, avec la tension générée de manière photovoltaïque, les composés contenant de l'hydrogène sont électrolysés et les protons formés par électrolyse sont dirigés de l'anode vers la cathode où ils sont réduits en hydrogène moléculaire, plusieurs unités suivant la position du soleil, constituées d'au moins un concentrateur et d'au moins une cellule photovoltaïque qui n'est pas en contact avec les composés contenant de l'hydrogène, qui est mise en contact électrique avec un électrolyseur constitué d'une cathode et d'une anode, étant utilisées, l'électrolyseur présentant une température de travail de -10°C à 200°C.

22. Procédé selon la revendication 21,
**caractérisé en ce que**, les cellules photovoltaïques utilisées sont constituées de plusieurs transitions pn ou np connectées entre elles en série, constituées de matériaux semi-conducteurs avec chacun une énergie de bande interdite différente des autres.

23. Procédé selon l'une des revendications 21 ou 22,
**caractérisé en ce que** les matériaux semi-conducteurs sont sélectionnés dans le groupe constitué du silicium, du germanium et de composés III-V d'aluminium, de gallium, d'indium ainsi que d'azote, de phosphore, d'arsenic ou d'antimoine.

24. Procédé selon l'une des revendications 21 à 23,
**caractérisé en ce que** le nombre de transitions pn ou np de la cellule photovoltaïque est choisi de façon à ce que la cellule photovoltaïque présente une tension de l'ordre de 1,5 à 6V.

25. Procédé selon l'une des revendications 21 à 24,
**caractérisé en ce que** la lumière est concentrée d'un facteur 50 à 1500, plus particulièrement d'un facteur 300 à 1000.

26. Procédé selon l'une des revendications 21 à 25,
**caractérisé en ce que** la lumière est concentrée avec une lentille optique à foyer ponctuel, plus particulièrement une lentille de Fresnel, d'un miroir en forme de cuvette à foyer ponctuel, d'une lentille optique à foyer linéaire ou d'un miroir parabolique.

27. Procédé selon l'une des revendications 21 à 26,
**caractérisé en ce que** l'électrolyseur utilisé est une membrane polymère perméable aux protons.

28. Procédé selon l'une des revendications 21 à 27,
**caractérisé en ce que** l'hydrogène provenant des unités est rassemblé et collecté.

29. Procédé selon l'une des revendications 21 à 28,
**caractérisé en ce que** l'hydrogène généré est évacué par l'intermédiaire d'un système de canaux.

30. Procédé selon l'une des revendications 21 à 29,
**caractérisé en ce que** les composés contenant de l'hydrogène sont utilisés pour le refroidissement, en laissant les composés contenant de l'hydrogène s'écouler le long des cellules photovoltaïques.

31. Procédé selon l'une des revendications 21 à 30,
**caractérisé en ce que** de l'oxygène moléculaire est généré en tant que sous-produit.

32. Procédé selon l'une des revendications 21 à 31,
**caractérisé en ce que** les composés contenant de l'hydrogène sont constitués principalement d'eau dé-ionisée.
